(19) Europäisches Patentamt
European Patent Office
Office européen des brevets

(11) **EP 4 554 026 A1**

(12) **EUROPEAN PATENT APPLICATION**

(43) Date of publication:
**14.05.2025 Bulletin 2025/20**

(21) Application number: **23209147.0**

(22) Date of filing: **10.11.2023**

(51) International Patent Classification (IPC):
$H02H\ 3/34$ (2006.01)    $H02H\ 3/40$ (2006.01)
$H02H\ 7/26$ (2006.01)    $G01R\ 31/08$ (2020.01)
$H02H\ 3/04$ (2006.01)

(52) Cooperative Patent Classification (CPC):
**H02H 3/405; G01R 19/2513; G01R 31/086;
G01R 31/088; H02H 3/34; H02H 7/26;** H02H 3/042

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Hitachi Energy Ltd
8050 Zürich (CH)**

(72) Inventors:
• **WANG, Jianping
724 60 Västerås (SE)**
• **LI, YouYi
722 19 Västerås (SE)**
• **GAJIC, Zoran
723 47 Västerås (SE)**

(74) Representative: **Vossius & Partner
Patentanwälte Rechtsanwälte mbB
Siebertstraße 3
81675 München (DE)**

(54) **LINE DISTANCE PROTECTION IN AN ELECTRICAL POWER SYSTEM BASED ON A REACH POINT VOLTAGE CALCULATION**

(57)    The present disclosure relates to a method for controlling or protecting the transmission line within an electrical system comprising a transmission line, the method comprising: obtaining measurements of a first at least one electrical parameter being measured at a first location on the transmission line of the electrical system; determining, in a time-domain, a second at least one electrical parameter for a second location on the transmission line of the electrical system based on the measurements of the first at least one electrical parameter; determining, in a frequency-domain, a third at least one electrical parameter for the second location on the transmission line of the electrical system based on the second at least one electrical parameter; and controlling or protecting the transmission line within the electrical system based on the third at least one electrical parameter.

$400$

Sampling values at relay point | $i_a, i_b, i_c, u_a, u_b, u_c$

S401 — Line differential equation (time domain)

Sampling values at reach point | $u'_a, u_b', u_c'$

S402 — DFT & sequence calculation

Seq. values at reach point | $U'_1, U_2', U_0'$

S403 — Fault detection and protection

FIG. 4

EP 4 554 026 A1

**Description**

The present disclosure relates to a method, a device, and a system for controlling and protecting an electrical system comprising a transmission line.

In an electrical system comprising a transmission line, it is of high importance to accurately identify a fault type for further corrective actions. Among others, a distance protection is widely used to protect the transmission line. However, due to the increasing use of variable renewable sources, it has become challenging for conventional methods to process the measurements due to distorted fault current waveforms and higher harmonic components, especially for Doubly fed induction generators (DFIG) connected transmission lines. The following briefly discusses the basic principle of the distance protection and the conventional methods being utilized therewith.

Conventionally, the distance protection relies on computing the measured line impedance, which reflects the positive-sequence impedance of protected transmission lines. The calculation is based on Ohm's law as given below: There may be two types of calculation loops for impedance measurements: 1) based on phase-to-ground loop and 2) based on phase-phase loop measurement. Phase-to-ground loop impedance may be computed as follows:

$$Z_{PG} = \frac{V_{PG}}{I_{PG} + K_0 I_0} \qquad (1)$$

wherein

$V_{PG}$ denotes a phase-to-ground voltage measured at a relay location of a transmission line,

$I_{PG}$ denotes a phase-to-ground loop current measured at a relay location of a transmission line such as $I_A$, $I_B$, $I_C$,

$I_0$ denotes a measured zero-sequence current from the three phase currents, i.e., $I_0 = \frac{1}{3}(I_A + I_B + I_C$,

$K_0$ denotes a compensation factor, e.g., $K_0 = \frac{Z_0 - Z_1}{Z_1}$,

$Z_0$ denotes a zero-sequence impedance as seen from the location of the relay to the end of the protected zone, and

$Z_1$ denotes a positive-sequence impedance as seen from the location of the relay to the end of the protected zone.

Phase-to-phase loop impedance may be computed as follows.

$$Z_{PP} = \frac{V_{Phase,1} - V_{phase,2}}{I_{Phase,1} - I_{phase,2}} \qquad (2)$$

Wherein $V_{Phase,1}$ and $V_{Phase,2}$ denote phase-to-ground voltages measured at the relay location of the transmission line, e.g., $V_A$ and $V_B$, $V_B$ and $V_C$, and $V_C$ and $V_A$, and wherein $I_{phase,1}$ and $I_{Phase,2}$ denote phase-to-ground voltages measured at the relay location of the transmission line, e.g., $I_A$ and $I_B$, $I_B$ and $I_C$, and $I_C$ and $I_A$.

As evident from the equations above, the calculations are based on Ohm's law, which requires that both the input variables such as voltages and currents must be in the same frequency domain. For 50 Hz power systems, those measurement inputs should be 50 Hz phasors, so as to justify the calculations above.

However, in case of variable renewable source connected lines, the measured voltages and currents in the variable renewable source side might not have the same frequencies during fault period, so that equations (1) and (2) might have errors in the calculation results. This may lead to misjudgements such as over-reach or under-reach for a distance protection.

In view of the above, a first method may utilize sequence voltages with the phase domain calculation to the distance protection reach point. The basic concept of this method is to calculate reach point sequence voltages: positive-sequence voltage at the reach point $V_{a1,rp}$, a negative-sequence voltage at the reach point $V_{a2,rp}$, and a zero-sequence voltage at the reach point $V_{a0,rp}$. Then, an operation quantity of eq. (3) and a restrain quantity of eq. (4) can be computed and compared with each other for AG fault in the reach point as an example.

$$V_{op} = V_{a0,rp} + V_{a2,rp} \qquad\qquad (3)$$

$$V_{restraint} = V_{a1,rp} \qquad\qquad (4)$$

If the operation quantity, $V_{op}$ is larger than restrain quantity, $V_{restraint}$, an internal fault within the protection zone can be determined, so that a trip signal can be issued. It is noted that equations (3) and (4) are computed for phase-A related unsymmetrical fault detection such as AG fault, ABG fault, ACG fault, AB fault, and AC fault. In case of phase-B related faults or phase-C related faults, the calculations of equations (3) and (4) may be based on the respective phase signals. For example, for a BG fault, the operation value may be formed by summation of $V_{b0,rp}$ and $V_{b2,rp}$, while the restrain quantity can be formed by using $V_{b1,rp}$. Here, the subscript b denotes the phase-B.

The reach point sequence voltages such as $V_{a1,rp}$, $V_{a2,rp}$, and $V_{a0,rp}$ can be calculated from the relay measurement point by subtracting the corresponding sequence voltage drops along the line.

$$V_{a1,rp} = V_{a1,IED} - Z_{1,set} \cdot I_{a1} \qquad\qquad (5)$$

$$V_{a2,rp} = V_{a2,IED} - Z_{2,set} \cdot I_{a2} \qquad\qquad (6)$$

$$V_{a0,rp} = V_{a0,IED} - Z_{0,set} \cdot I_{a0} \qquad\qquad (7)$$

Here, $Z_{1,set}$, $Z_{2,set}$, and $Z_{3,set}$ denote a positive-sequence impedance, a negative-sequence impedance and a zero-sequence impedance from relay location to the reach point, respectively. It is also possible to calculate the reach point voltages by using original three phase transmission line self-impedances and coupling impedances with original three phase currents in phase domain as follows.

$$\begin{pmatrix} U_{a,RP} \\ U_{b,RP} \\ U_{c,RP} \end{pmatrix} = Reach_{setting} \times \begin{pmatrix} Z_{Sa} & Z_{ab} & Z_{ac} \\ Z_{ab} & Z_{Sb} & Z_{bc} \\ Z_{ac} & Z_{bc} & Z_{Sc} \end{pmatrix} \times \begin{pmatrix} I_A \\ I_B \\ I_C \end{pmatrix} \qquad\qquad (8)$$

Here, $Z_{Sa}$, $Z_{Sb}$, and $Z_{Sc}$ denote a transmission line self-impedance for phase a, phase b and phase c within three phase transmission lines, respectively, and $Z_{ab}$, $Z_{ac}$, and $Z_{bc}$ denote the coupling impedance between two phases such as AB, BC, and AC.

If the three phase lines are transposed with the same coupling impedance between each two phases and same self-impedance, then we have $Z_{ab} = Z_{ac} = Z_{bc} = Z_{mm}$, and $Z_{Sa} = Z_{Sb} = Z_{Sc} = Z_S$. $I_A$, $I_B$, and $I_C$ are three phase currents in phasor domain. $U_{a,RP}$, $U_{b,RP}$, and $U_{c,RP}$ are phasor domain voltages calculated to the reach point based on setting value as "$Reach_{setting}$", which is normally equal to 0.8 as 80% of the line length for a typical setting for line protection. The reach point voltage calculation can also be done with other methods such as distributed transmission line modelling either based on telegraph equations or based on hyperbolic trigonometric functions for receiving end and sending end voltage calculations for long lines. Alternatively, a method may utilize a Pi-model based on lump line parameters for short length of lines.

The sequence voltage at the reach point (normally it is 80% of line distance protection setting known as Zone 1 can then be calculated as follows.

$$\begin{pmatrix} U_{0,RP} \\ U_{1,RP} \\ U_{2,RP} \end{pmatrix} = \frac{1}{3} \begin{pmatrix} 1 & 1 & 1 \\ 1 & a & a^2 \\ 1 & a^2 & a \end{pmatrix} \begin{pmatrix} U_{a,RP} \\ U_{b,RP} \\ U_{c,RP} \end{pmatrix} \qquad\qquad (9)$$

Here, in the complex plane, $a = -0.5+j0.866$, $a^2 = -0.5-j0.866$ in equation (9), wherein j designates the imaginary part.

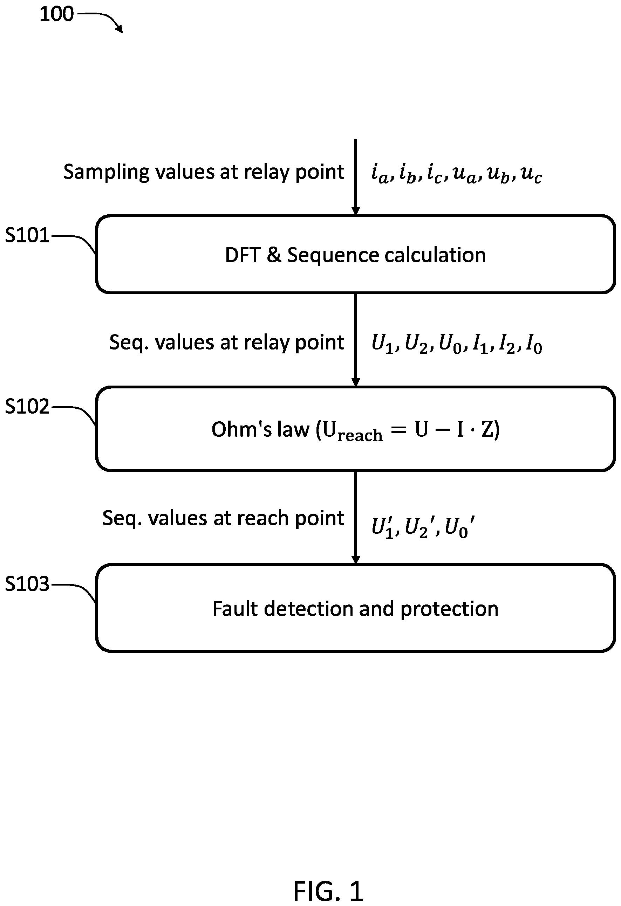

Equations (5), (6), and (7) have used the sequence current to multiply the corresponding sequence impedance, i.e., Ohm's law has been used in the calculation. It is also noted that the calculation method based on equation (8) is also based on Ohm's law. The conventional computational method as described above is summarized in Fig. 1.

Fig. 1 illustrates a flow chart of a conventional computational method. The method 100 computes sequence values at a relay point $U_1$, $U_2$, $U_0$, $I_1$, $I_2$, $I_0$ by firstly converting sampling values at the relay point $i_a$, $i_b$, $i_c$, $u_a$, $u_b$, $u_c$ into frequency domain, and subsequently computing sequence values (S101). Then, the sequence values at a reach point $U_1'$, $U_2'$, $U_0'$ are computed based on Ohm's law using the sequence values at a relay point $U_1$, $U_2$, $U_0$, $I_1$, $I_2$, $I_0$ (S102). Accordingly, the fault is detected (S103) and corresponding protection action may be issued.

However, the conventional method introduces errors particularly due to signal distortions caused in an electrical system comprising a transmission line, wherein the transmission line is electrically coupled to a, e.g. variable, renewable source. The variable renewable resources may be converters-controlled power plants, in particular including a non-linear controller.

Thus, there is a need for an improve method, device, and system for controlling an electrical system comprising a transmission line.

The present disclosure relates to a method for controlling and protecting an electrical system comprising a transmission line, the method comprising: obtaining measurements of a first at least one electrical parameter being measured at a first location on the transmission line of the electrical system; determining, in a time-domain , a second at least one electrical parameter for a second location on the transmission line of the electrical system based on the measurements of the first at least one electrical parameter; determining, in a frequency-domain, a third at least one electrical parameter for the second location on the transmission line of the electrical system based on the second at least one electrical parameter; and controlling or protecting the transmission line of (within) the electrical system based on the third at least one electrical parameter. In this way, the calculation errors introduced due to wave distortion such as frequency shifting, harmonics as well as decaying DC components are minimized comparing with Ohm's law-based calculation solution.

Various embodiments may preferably implement the following features:
Preferably, determining the second at least one electrical parameter comprises solving at least one time-domain differential equation; and/or determining the third at least one electrical parameter comprises transforming the second at least one electrical parameter in the time-domain to the frequency-domain.

Preferably, determining an internal fault occurrence based on the third at least one electrical parameter and at least one pre-set condition; and controlling or protecting the transmission line of (within) the electrical system further based on the determined internal fault occurrence.

Preferably, the transmission line comprises a plurality of phases being carried along the transmission line, in particular three phases.

Preferably, the first at least one electrical parameter is a current and/or voltage of the respective plurality of phases; the second at least one electrical parameter is a voltage, in particular at a reach point, of the respective plurality of phases; and/or the third at least one electrical parameter is a sequence voltage, in particular at the reach point, of the respective plurality of sequence voltages.

Preferably, the method further comprises: determining at least one phase of the plurality of phases involved in a fault based on the third at least one electrical parameter; and controlling the electrical system further based on the determined at least one phase involved in the fault.

Preferably, the fault is any one of a phase-to-ground fault, a phase-to-phase fault, and a phase-to-phase-to-ground fault.

Preferably, the electrical system comprises a transmission line protection system within the electrical system, wherein the transmission line protection system preferably comprises a relay, in particulara distance relay; and controlling, in particular tripping, the transmission line protection system based on a control signal generated according to the third at least one electrical parameter.

Preferably, the second location is different from the first location.

Preferably, the transmission line is terminated by a first terminal at a first end of the transmission line, and the transmission line is terminated by a second terminal at a second end of the transmission line, wherein the first end is different from the second end.

Preferably, the electrical system further comprises a first source being electrically coupled to the first end of the transmission line and a second source being electrically coupled to the second end of the transmission line.

Preferably, at least one of the first source and the second source is a renewable resource, in particular a variable renewable resource.

Preferably, at least a portion of the transmission line between the first terminal and the second terminal is protected, in particular using a further protection system, more particularly a distance protection system.

Preferably, controlling or protecting the transmission line of (within) the electrical system is or comprises tripping a circuit breaker. The circuit breaker may isolate a first portion of the transmission line upon which a fault occurs from a second portion of the transmission line, wherein the first potion of the transmission line is different from the second portion of the transmission line.

The present disclosure also relates to a device for controlling an electrical system comprising a transmission line, the device comprising a processor being configured to: obtain measurements of a first at least one electrical parameter being measured at a first location on the transmission line of the electrical system; determine, in a time-domain, a second at least one electrical parameter for a second location on the transmission line of the electrical system based on the measurements of the first at least one electrical parameter; determine, in a frequency-domain, a third at least one electrical parameter for the second location on the transmission line of the electrical system based on the second at least one electrical parameter; and control or protecting the transmission line of (within) the electrical system based on the third at least one electrical parameter.

Preferably, the processor is configured to perform the method according to any one of the preferred embodiments disclosed herein.

The present disclosure also relates to a system for controlling an electrical system comprising a transmission line, the system comprising the electrical system and the device according to any one of the preferred embodiments disclosed herein.

Various exemplary embodiments of the present disclosure disclosed herein are directed to providing features that will become readily apparent by reference to the following description when taken in conjunction with the accompanying drawings. In accordance with various embodiments, exemplary systems, methods, and devices are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

Thus, the present disclosure is not limited to the exemplary embodiments and applications described and illustrated herein. Additionally, the specific order and/or hierarchy of steps in the methods disclosed herein are merely exemplary approaches. Based upon design preferences, the specific order or hierarchy of steps of the disclosed methods or processes can be re-arranged while remaining within the scope of the present disclosure. Thus, those of ordinary skill in the art will understand that the methods and techniques disclosed herein present various steps or acts in a sample order, and the present disclosure is not limited to the specific order or hierarchy presented unless expressly stated otherwise.

The above and other aspects and their implementations are described in greater detail in the drawings, the descriptions, and the claims.

**Description of the Drawings**

Fig. 1 illustrates a flow chart of a conventional computational method.

Fig. 2 illustrates a flow chart of a method for controlling or protecting the transmission line of an electrical system comprising a transmission line.

Fig. 3 illustrates a system comprising the electrical system according to an embodiment of the present disclosure.

Fig. 4 illustrates a method for controlling or protecting the transmission line of an electrical system comprising a transmission line according to an embodiment of the present disclosure.

Fig. 5 illustrates simulation results including currents and voltages measured at local relay in one end of transmission line of the electrical system according to an embodiment of the present disclosure.

Fig. 6 illustrates a data stream of computed voltages determined based on the method according to an embodiment of the present disclosure.

Fig. 7 illustrates a data stream of computed voltages determined based on a conventional method shown in Fig. 1.

Fig. 8a) illustrates a device implemented according to an embodiment of the present disclosure.

Fig. 8b) illustrates an electrical system implemented according to an embodiment of the present disclosure.

Fig. 8c) illustrates a system implemented according to an embodiment of the present disclosure.

In the following, exemplary embodiments of the disclosure will be described. It is noted that some aspects of any one of the described embodiments may also be found in some other embodiments unless otherwise stated or obvious.

However, for increased intelligibility, each aspect will only be described in detail when first mentioned and any repeated description of the same aspect will be omitted.

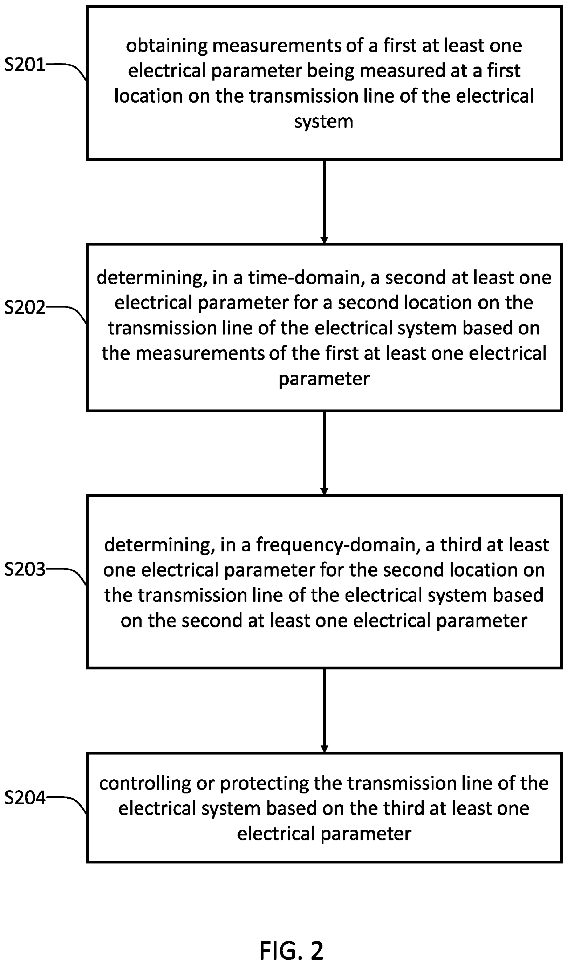

FIG. 2 illustrates a flow chart of a method for controlling an electrical system comprising a transmission line. In an embodiment, the transmission line is terminated by a first terminal at a first end of the transmission line, and the transmission line is terminated by a second terminal at a second end of the transmission line, wherein the first end is different from the second end. In an embodiment, the transmission line carries a plurality of phases, in particular three phases. In an embodiment, the electrical system further comprises a first source being electrically coupled to the first end of the transmission line and a second source being electrically coupled to the second end of the transmission line. In an embodiment, at least one of the first source and the second source is a renewable resource. In an embodiment, at least a portion of the transmission line between the first terminal and the second terminal is protected, in particular using a further protection system, more particularly a distance protection system.

At S201, measurements of a first at least one electrical parameter being measured at a first location on the transmission line of the electrical system are obtained. It is understood by the skilled person that the term "obtain" may refer to the action of receiving. That is, the measurements may be received. For instance, the measurements may be received from a device comprising at least one measurement unit, wherein the at least one measurement unit is configured to measure the first at least one electrical parameter. In an embodiment the device comprises a communication unit, wherein the communication unit is configured to communicate information, in particular transmit information such as the measurements and/or receive information such as a fault location, a trip signal, or the like. In an embodiment, the device comprises a protection element, in particular a tripping element such as a relay. In an embodiment, the device comprises a processor being configured to perform the method shown in Fig. 2. In an embodiment, the at least one measurement unit measures the at least one electrical parameter at the first location on the transmission line or at the second location on the transmission line.

At 5202, a second at least one electrical parameter for a second location on the transmission line of the electrical system is determined, in a time-domain, based on the measurements of the first at least one electrical parameter. It is understood by the skilled person that the term "determine" may bear the same meaning as, thus can be interchangeably used with, other terms such as "calculate", "compute", or the like. In an embodiment, determining the second at least one electrical parameter comprises solving at least one time-domain equation, in particular at least one time-domain differential equation. In an embodiment, the determined second at least one electrical parameter is in the time-domain. In an embodiment, the second at least one electrical parameter is a voltage, in particular a reach point voltage, of the respective plurality of phases. Alternatively, or in addition, the second at least one electrical parameter is a current of the respective plurality of phases. The reach point may be the point along the transmission line impedance locus that is intersected by the boundary characteristic, in particular of a protection element, more particularly a tripping element such as a relay. In an embodiment, the second location is different from the first location.

At S203, a third at least one electrical parameter for the second location on the transmission line of the electrical system is determined, in a frequency-domain, based on the second at least one electrical parameter. In an embodiment, determining the third at least one electrical parameter comprises transforming the second at least one electrical parameter in the time-domain to the frequency-domain. In an embodiment, the third at least one electrical parameter is a sequence voltage, in particular at reach point, of the respective plurality of sequence voltages.

At 5204, the transmission line of (within) the electrical system is controlled or protected based on the third at least one electrical parameter.

In an embodiment, determining the second at least one electrical parameter comprises solving at least one time-domain differential equation; and/or determining the third at least one electrical parameter comprises transforming the second at least one electrical parameter in the time-domain to the frequency-domain.

In an embodiment, the method further comprises determining an internal fault occurrence based on the third at least one electrical parameter and at least one pre-set condition; and controlling or protecting the transmission line of (within) the electrical system further based on the determined internal fault occurrence.

In an embodiment, the method further comprises determining a fault location based on the third at least one electrical parameter and at least one pre-set condition; and controlling or protecting the transmission line of (within) the electrical system further based on the determined fault location.

In an embodiment, the transmission line comprises a plurality of phases being carried along the transmission line, in particular three phases.

In an embodiment, the first at least one electrical parameter is a current and/or voltage of the respective plurality of phases; the second at least one electrical parameter is a voltage, in particular at a reach point, of the respective plurality of phases; and/or the third at least one electrical parameter is a sequence voltage, in particular at the reach point, of the respective plurality of sequence voltages.

In an embodiment, the method further comprises determining at least one phase of the plurality of phases involved in a fault based on the third at least one electrical parameter; and controlling or protecting the transmission line of (within) the electrical system further based on the determined at least one phase involved in the fault.

In an embodiment, the fault is any one of a phase-to-ground fault, a phase-to-phase fault, and a phase-to-phase-to-ground fault.

In an embodiment, the electrical system comprises a transmission line protection system within the electrical system, wherein the transmission line protection system preferably comprises a relay, in particular a distance relay; and controlling, in particular tripping, the transmission line protection system based on a control signal generated according to the third at least one electrical parameter.

In an embodiment, the second location is different from the first location.

In an embodiment, the method shown in Fig. 2 is for controlling a distance protection, wherein the distance protection protects the transmission line comprised in the electrical system.

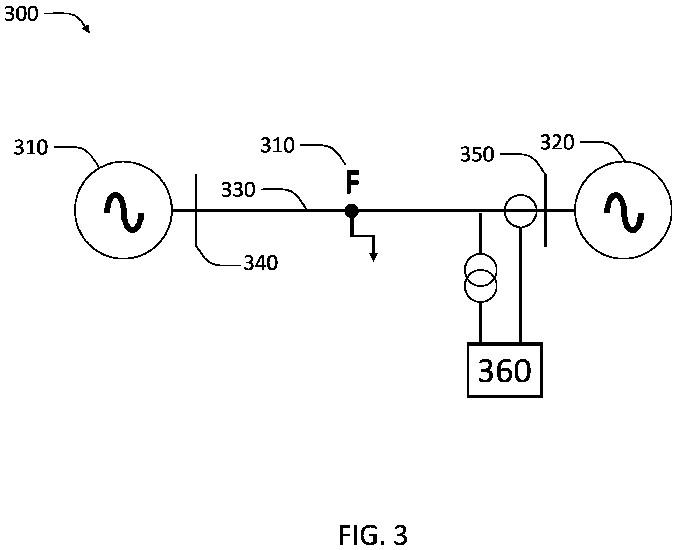

Fig. 3 illustrates a system comprising the electrical system according to an embodiment of the present disclosure. The system 300 comprises a transmission line 330. The transmission line 330 is terminated by a first terminal 340 at a first end of the transmission line and the transmission line 330 is terminated by a second terminal 350 at a second end of the transmission line, wherein the first end is different from the second end. The transmission line carries three different phases, i.e., phase-A, phase-B, and phase-C. The electrical system further comprises a first source 310 being electrically coupled to the first end of the transmission line and a second source 320 being electrically coupled to the second end of the transmission line. The system 300 further comprises a relay 360 being communicatively coupled to a voltage sensor and to a current sensor for measuring the voltages and currents, respectively, of the three phases carried on the transmission line. In an embodiment, the relay 360 comprises the voltage sensor and the current sensor. In an embodiment, a device, in particular an intelligent electronic device, is or comprises the relay 360. In an embodiment, the device comprises a processor being configured to perform the method according to any one of the embodiments disclosed herein. The voltages and currents of the three phases carried on the transmission line are measured at a line end of the second terminal 350. For example, in case the line length is 100 km, the measurement points (first and second terminal 350 and 340) may be closely located at the two respective ends of the line. The distance between the end of the line and the respective measurement points may be a couple of meters depending on the current transformer locations. The measurements are performed before, during, and/or after a fault occurs. A fault location 310 on the transmission line is indicated by the letter "F" on Fig. 3.

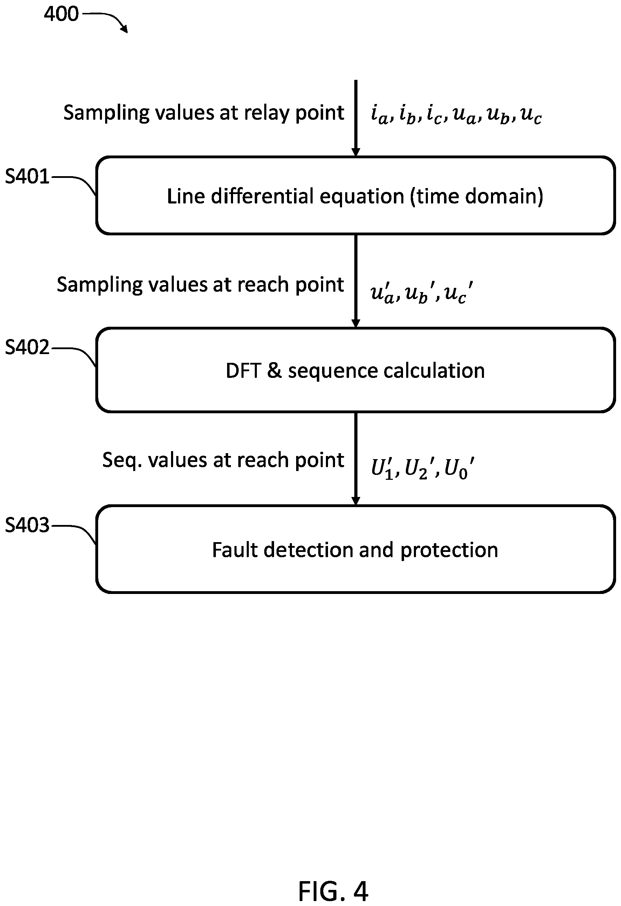

Fig. 4 illustrates a method for controlling an electrical system comprising a transmission line according to an embodiment of the present disclosure. The method shown in Fig. 4 may be a specific embodiment of the method shown in Fig. 2. For illustrative purposes, the method 400 is described herein in reference to the system illustrated in Fig. 3, but the application of the method 400 is not limited thereto.

The method 400 obtains sampling values at a relay point, i.e., a measurement point on the transmission line 330. The sampling values may be the three phase currents $i_a$, $i_b$, and $i_c$ and the three phase voltages $u_a$, $u_b$, and $u_c$ being carried on the transmission line 330. The sampling values may comprise the measurements measured before, during and/or after a fault occurs. The sampling values may be the measurements of a first at least one electrical parameter in S201.

At S401, sampling values at a reach point $u'_a$, $u_b'$, $u_c'$ are computed by solving at least one time-domain line differential equation based on the sampling values at relay point $i_a$, $i_b$, $i_c$, $u_a$, $u_b$, and $u_c$. In an embodiment, the following three time-domain lines differential equations are solved.

$$u_{a,RP}(t) = u_a(t) - \left[ R \cdot \left( i_a(t) + k_R \cdot 3i_0(t) \right) + L \cdot \frac{d\left( i_a(t) + k_L \cdot 3i_0(t) \right)}{dt} \right] \qquad (10)$$

$$u_{b,RP}(t) = u_b(t) - \left[ R \cdot \left( i_b(t) + k_R \cdot 3i_0(t) \right) + L \cdot \frac{d\left( i_b(t) + k_L \cdot 3i_0(t) \right)}{dt} \right] \qquad (11)$$

$$u_{c,RP}(t) = u_c(t) - \left[ R \cdot \left( i_c(t) + k_R \cdot 3i_0(t) \right) + L \cdot \frac{d\left( i_a(t) + k_L \cdot 3i_0(t) \right)}{dt} \right] \qquad (12)$$

wherein

$u_{a,RP}(t)$ denotes a reach point phase-A voltage in time domain,
$u_{b,RP}(t)$ denotes a reach point phase-B voltage in time domain,
$u_{c,RP}(t)$ denotes a reach point phase-C voltage in time domain,

$$k_R = \frac{R_0 - R_1}{3R_1} \text{ and } k_X = \frac{X_0 - X_1}{3X_1},$$

$i_0$ denotes a zero-sequence current,
$R_0$ denotes a zero-sequence resistance to the reach point and
$X_0$ denotes a zero-sequence reactance to the reach point.

In an embodiment, $u_{a,RP}(t)$, $u_{b,RP}(t)$, and $u_{c,RP}(t)$ correspond to the sampling values at reach point $u_a'$, $u_b'$, and $u_c'$, respectively. S401 may correspond to S202.

At S402, sequence values at the reach point $U_1'$, $U_2'$, $U_0'$ are determined in frequency domain based on the sampling values at a reach point $u_a'$, $u_b'$, $u_c'$. In particular, the sampling values at the reach point $u_a'$, $u_b'$, $u_c'$ may be converted into frequency domain signals by Discrete Fourier transformation, DFT, and the sequence values at the reach point $U_1'$, $U_2'$, $U_0'$ may be computed based on the converted frequency domain signals. S402 may correspond to S203. In an embodiment, a full cycle Fourier Transformation is used as follows.

$$\begin{pmatrix} U_{a,RP} \\ U_{b,RP} \\ U_{c,RP} \end{pmatrix} = \frac{1}{T} \begin{pmatrix} \int_{t_0}^{t_0+T} u_{a,RP}(t)e^{-jwt}dt \\ \int_{t_0}^{t_0+T} u_{b,RP}(t)e^{-jwt}dt \\ \int_{t_0}^{t_0+T} u_{c,RP}(t)e^{-jwt}dt \end{pmatrix} \quad (13)$$

wherein

$U_{a,RP}$ denotes the reach point phase-A voltage in phasor domain,
$U_{b,RP}$ denotes the reach point phase-B voltage in phasor domain,
$U_{c,RP}$ denotes the reach point phase-C voltage in phasor domain,
T denotes a one fundamental power frequency cycle time, e.g., T=20ms for a 50 Hz AC system,
$t_0$ denotes a time instant to start Fourier transformation, and
$\omega$ denotes an angular velocity, e.g., $\omega = 2\pi f \approx 314$ for a 50 Hz AC system.

Subsequently the sequence values at the reach point may be obtained as follows.

$$\begin{pmatrix} U_{0,RP} \\ U_{1,RP} \\ U_{2,RP} \end{pmatrix} = \frac{1}{3} \begin{pmatrix} 1 & 1 & 1 \\ 1 & a & a^2 \\ 1 & a^2 & a \end{pmatrix} \begin{pmatrix} U_{a,RP} \\ U_{b,RP} \\ U_{c,RP} \end{pmatrix} \quad (14)$$

wherein, $a = -0.5 + j0.866$ and $a^2 = -0.5 - j0.866$.

At S403, the fault is identified (detected) based on the sequence values at the reach point $U_1'$, $U_2'$, $U_0'$. In an embodiment, the fault identification (detection and subsequent protection) comprises or is determining at least one of the plurality of phases being carried on the transmission line 330, that is involved in the fault. For instance, the following criteria may be used to determine the phase involved in the fault.

$$IF \; U_{opA} > U_{restrainA}, \text{phase A related faults} \quad (15)$$

$$IF \; U_{opB} > U_{restrainB}, \text{phase B realted faults} \quad (16)$$

$$IF\ U_{opC} > U_{retrainC},\ \text{phase C related faults} \qquad (17)$$

wherein

$$U_{opA} = U_{2,RP} + U_{0,RP} \qquad (18)$$

$$U_{opB} = a \cdot U_{2,RP} + U_{0,RP} \qquad (19)$$

$$U_{opC} = a^2 \cdot U_{2,RP} + U_{0,RP} \qquad (20)$$

$$U_{restrainA} = U_{1,RP} \qquad (21)$$

$$U_{restrainB} = a^2 \cdot U_{1,RP} \qquad (22)$$

$$U_{restrainC} = a \cdot U_{1,RP} \qquad (23)$$

The fault may be an unsymmetrical fault, i.e., any one of a phase-to-ground fault, a phase-to-phase fault, and a phase-to-phase-to-ground fault. The fault may be an internal fault. The internal fault may be a fault occurring within a protection zone reaching point. For example, Zone 1 setting is usually set to 80% of line length. In this case, all faults within 80% of line length from relay measurement point until reaching point will be considered as internal faults. The fault may be an external fault. All faults beyond the reach point of the line may be considered as external faults. and it is required not act to trip. The determined fault types may be further processed. For instance, the method may further comprise generating a control signal, in particular a trip signal, based on the determined fault type. The transmission line of (within) electrical system shown in Fig. 3 may be controlled or protected based on the control signal, e.g., the relay 360 may or may not trip based on the control signal. In particular, the relay 360 or a circuit breaker (omitted in Fig. 3) may be tripped based on the control signal, wherein the control signal is generated upon determining an internal fault.

Hereinafter, the following configuration of the system 300 shown in Fig. 3 is considered, unless otherwise stated: the transmission line carries three phases, i.e., phases A, B, and C, the first source 310 is an AC grid, the second source 320 is a type-3 wind farm generator, and 80% of the line length of the transmission line is set as the reach point.

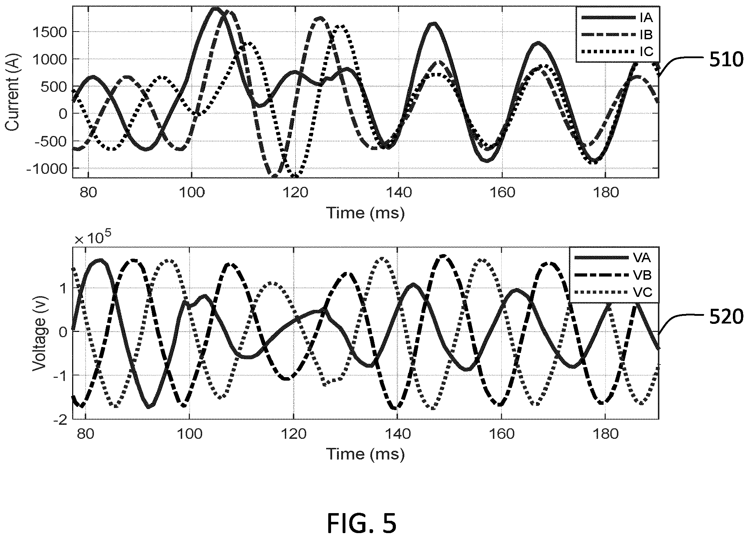

Fig. 5 illustrates simulation results of the electrical system according to an embodiment of the present disclosure. Subplot 510 illustrates a data stream of three phase currents $i_a$, $i_b$, and $i_c$ which are measured at the transmission line 330 end of the second terminal 350. Subplot 520 illustrates a data stream of three phase voltages $u_a$, $u_b$, and $u_c$ which are measured at the transmission line 330 end of the second terminal 350. The fault occurs at time $t = 100$ ms with fault location at Zone 1 boundary (80% of line length from measurement point). The simulated fault is a phase-to-ground fault, in particular phase-A to ground fault. The data streams illustrated in subplots 510 and 520 may form the basis of the method according to an embodiment of present disclosure.

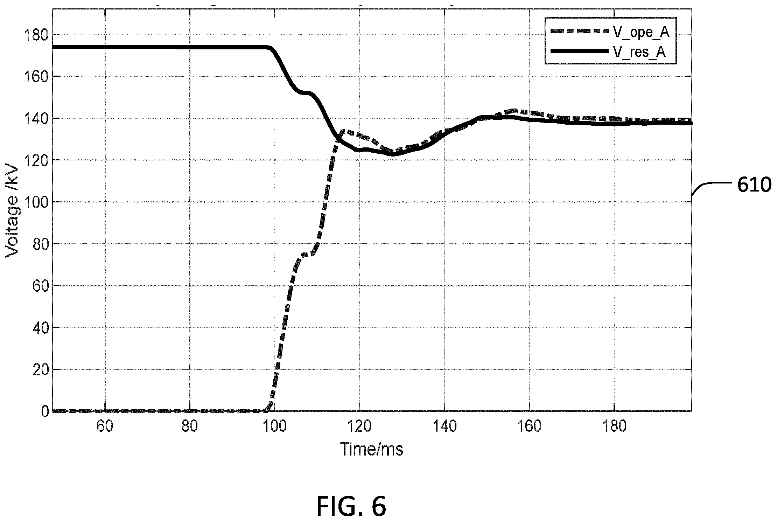

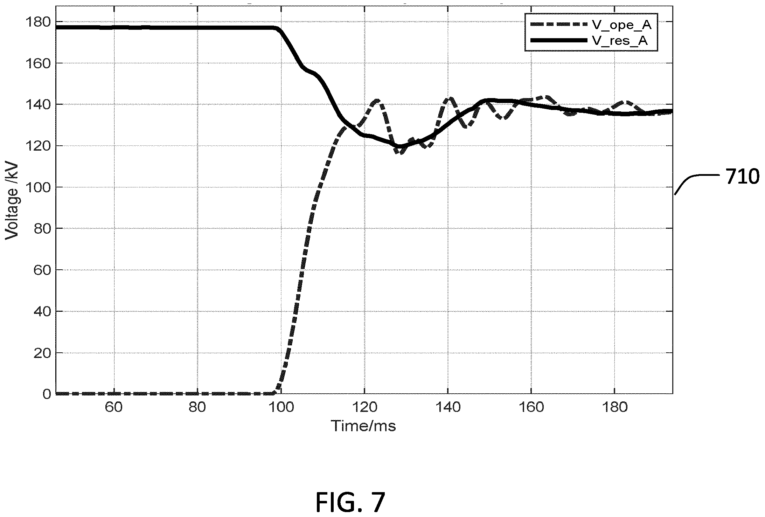

Fig. 6 illustrates a data stream of computed voltages determined based on the method according to an embodiment of the present disclosure. Plot 610 illustrates $U_{opA}$ and $U_{restrainA}$ computed using the data streams illustrated in subplots 510 and 520 and based on the method shown in the flow chart of Fig. 4. The phase-A-to-ground fault may be determined based on the criterion of eq. (15). For illustrative purposes, $U_{opA}$ and $U_{restrainA}$ computed based on the method shown in Fig. 1 is shown in Fig. 7. Plot 710 illustrates $U_{opA}$ and $U_{restrainA}$ computed using the data streams illustrated in subplots 510 and 520.

As evident from Fig. 6 and Fig. 7, $U_{opA}$ and $U_{restrainA}$ computed based on the method according to an embodiment of the present disclosure, i.e., the results shown in Fig. 6, fluctuates comparatively less than those computed based on a conventional method, i.e., the results shown in Fig. 7. Considering $U_{restrainA}$ as a reference, the maximum error is 3% and 16% for the results obtained based on the method according to an embodiment of the present disclosure and on the conventional method, respectively.

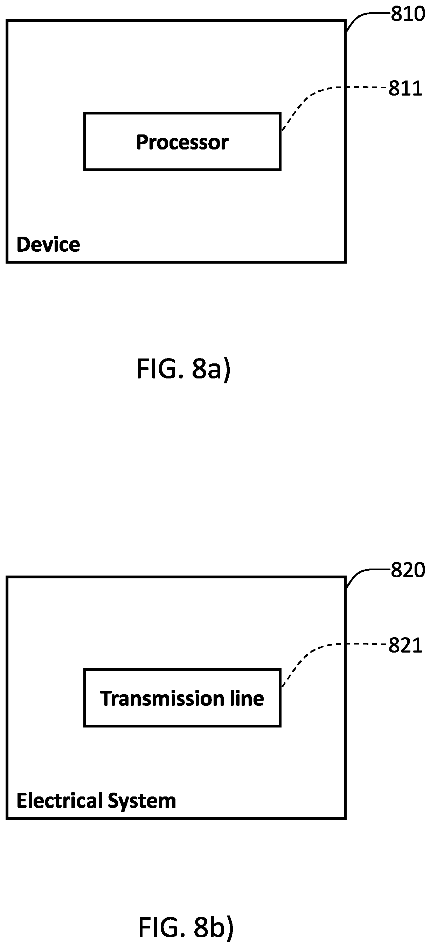

Fig. 8a) illustrates a device implemented according to an embodiment of the present disclosure. The device 810 may be a device for controlling an electrical system comprising a transmission line, the device comprising a processor 811 being configured to: obtain measurements of a first at least one electrical parameter being measured at a first location on the transmission line of the electrical system; determine, in a time-domain, a second at least one electrical parameter for a second location on the transmission line of the electrical system based on the measurements of the first at least one electrical parameter; determine, in a frequency-domain, a third at least one electrical parameter for the second location on the transmission line of the electrical system based on the second at least one electrical parameter; and control or protecting the transmission line of (within) the electrical system based on the third at least one electrical parameter.

In an embodiment, the processor 811 is configured to perform the method according to any one of the embodiments disclosed herein.

Fig. 8b) illustrates an electrical system implemented according to an embodiment of the present disclosure. The electrical system 820 comprises a transmission line 821. The electrical system 820 may be controlled by the method according to any one of the embodiments disclosed herein.

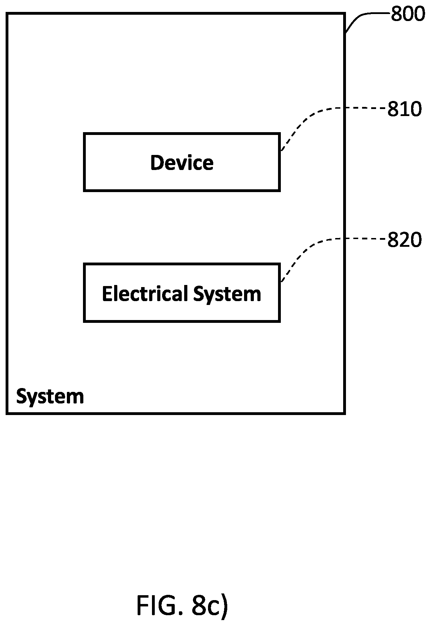

Fig. 8c) illustrates a system implemented according to an embodiment of the present disclosure. The system 800 may be a system 800 for controlling an electrical system 820 comprising a transmission line 821, the system 800 comprising the electrical system 820 and the device 810 according to any one of the embodiments disclosed herein.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements.

Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any of the various illustrative logical blocks, units, processors, means, circuits, methods and functions described in connection with the aspects disclosed herein can be implemented by electronic hardware (e.g., a digital implementation, an analogue implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative methods, logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

## Claims

**1.** A method for controlling an electrical system comprising a transmission line, the method comprising:

obtaining measurements of a first at least one electrical parameter being measured at a first location on the transmission line of the electrical system;

determining, in a time-domain, a second at least one electrical parameter for a second location on the transmission line of the electrical system based on the measurements of the first at least one electrical parameter;

determining, in a frequency-domain, a third at least one electrical parameter for the second location on the transmission line of the electrical system based on the second at least one electrical parameter; and

controlling or protecting the transmission line of the electrical system based on the third at least one electrical parameter.

**2.** The method of claim 1, wherein

determining the second at least one electrical parameter comprises solving at least one time-domain differential equation; and/or

determining the third at least one electrical parameter comprises transforming the second at least one electrical parameter in the time-domain to the frequency-domain.

**3.** The method of claim 1 or 2, further comprising:

determining an internal fault occurrence based on the third at least one electrical parameter and at least one pre-set condition; and

controlling or protecting the transmission line within the electrical system further based on the determined internal fault occurrence.

**4.** The method of any one of claims 1 to 3, further comprising:

determining a fault location based on the third at least one electrical parameter and at least one pre-set condition; and

controlling the electrical system further based on the determined fault location.

**5.** The method of any one of claims 1 to 4, wherein the transmission line comprises a plurality of phases being carried along the transmission line, in particular three phases.

**6.** The method of claim 5, wherein

the first at least one electrical parameter is a current and/or voltage of the respective plurality of phases;

the second at least one electrical parameter is a voltage, in particular at a reach point, of the respective plurality of phases; and/or

the third at least one electrical parameter is a sequence voltage, in particular at the reach point, of the respective plurality of sequence voltages.

7. The method of claim 5 or 6, further comprising:

determining at least one phase of the plurality of phases involved in a fault based on the third at least one electrical parameter; and

controlling or protecting the transmission line of the electrical system further based on the determined at least one phase involved in the fault.

8. The method of any one of claims 5 to 7, wherein the fault is any one of a phase-to-ground fault, a phase-to-phase fault, and a phase-to-phase-to-ground fault.

9. The method of any one of claims 1 to 8, wherein

the electrical system comprises a transmission line protection system within the electrical system, wherein the transmission line protection system preferably comprises a relay, in particular a distance relay; and

controlling or protecting the transmission line of the electrical system comprises controlling, in particular tripping, the transmission line protection system based on a control signal generated according to the third at least one electrical parameter.

10. The method of any one of claims 1 to 9, wherein the second location is different from the first location.

11. The method of any one of claims 1 to 10, wherein controlling or protecting the transmission line of the electrical system based on the third at least one electrical parameter comprises protecting the electrical system based on the third at least one electrical parameter, preferably including issuing a trip comment to a corresponding circuit breaker and thereby isolating a respective fault.

12. A device for controlling or protecting the transmission line of an electrical system comprising a transmission line, the device comprising a processor being configured to:

obtain measurements of a first at least one electrical parameter being measured at a first location on the transmission line of the electrical system;

determine, in a time-domain, a second at least one electrical parameter for a second location on the transmission line of the electrical system based on the measurements of the first at least one electrical parameter;

determine, in a frequency-domain, a third at least one electrical parameter for the second location on the transmission line of the electrical system based on the second at least one electrical parameter; and

control or protecting the transmission line of the electrical system based on the third at least one electrical parameter.

13. The device of claim 12, wherein the processor is configured to perform the method of any one of claims 2 to 11.

14. A system for controlling or protecting the transmission line of an electrical system comprising a transmission line, the system comprising the electrical system and the device of claim 12 or 13.

$100$

Sampling values at relay point $\quad i_a, i_b, i_c, u_a, u_b, u_c$

S101
```
DFT & Sequence calculation
```

Seq. values at relay point $\quad U_1, U_2, U_0, I_1, I_2, I_0$

S102
```
Ohm's law (U_reach = U − I · Z)
```

Seq. values at reach point $\quad U_1', U_2', U_0'$

S103
```
Fault detection and protection
```

FIG. 1

S201 — obtaining measurements of a first at least one electrical parameter being measured at a first location on the transmission line of the electrical system

S202 — determining, in a time-domain, a second at least one electrical parameter for a second location on the transmission line of the electrical system based on the measurements of the first at least one electrical parameter

S203 — determining, in a frequency-domain, a third at least one electrical parameter for the second location on the transmission line of the electrical system based on the second at least one electrical parameter

S204 — controlling or protecting the transmission line of the electrical system based on the third at least one electrical parameter

FIG. 2

FIG. 3

400 —↘

Sampling values at relay point $\quad i_a, i_b, i_c, u_a, u_b, u_c$

S401 ——

| Line differential equation (time domain) |

Sampling values at reach point $\quad u_a', u_b', u_c'$

S402 ——

| DFT & sequence calculation |

Seq. values at reach point $\quad U_1', U_2', U_0'$

S403 ——

| Fault detection and protection |

FIG. 4

FIG. 5

FIG. 6

FIG. 7

EP 4 554 026 A1

810

811

Processor

Device

FIG. 8a)

820

821

Transmission line

Electrical System

FIG. 8b)

FIG. 8c)

Europäisches
Patentamt

European
Patent Office

Office européen
des brevets

**EUROPEAN SEARCH REPORT**

Application Number

EP 23 20 9147

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SCHWEITZER EDMUND O ET AL: "Distance protection: Why have we started with a circle, does it matter, and what else is out there?", 2018 71ST ANNUAL CONFERENCE FOR PROTECTIVE RELAY ENGINEERS (CPRE), IEEE, 26 March 2018 (2018-03-26), pages 1-19, XP033336067, DOI: 10.1109/CPRE.2018.8349791 [retrieved on 2018-04-25] | 1-5,7-14 | INV. H02H3/34 H02H3/40 H02H7/26 G01R31/08 ADD. H02H3/04 |
| Y | * abstract * * Section V * | 6 | |
| X | CN 103 296 652 B (STATE GRID CORP CHINA; FUJIAN ELECTRIC POWER CO LTD ET AL.) 2 March 2016 (2016-03-02) * the whole document * | 1-5,9-14 | |
| Y | CN 115 061 020 A (GUANGZHOU POWER SUPPLY BUREAU GUANGDONG POWER GRID CO LTD) 16 September 2022 (2022-09-16) * the whole document * | 6 | TECHNICAL FIELDS SEARCHED (IPC) H02H G01R |
| A | WO 2018/227466 A1 (ABB SCHWEIZ AG [CH]; LIU KAI [CN]; WANG JIANPING [SE]; LI YOUYI [SE]) 20 December 2018 (2018-12-20) * page 4 - page 10 * | 1-14 | |

The present search report has been drawn up for all claims

| Place of search | Date of completion of the search | Examiner |
|---|---|---|
| Munich | 19 April 2024 | Palukova, Mila |

EPO FORM 1503 03.82 (P04C01)

## ANNEX TO THE EUROPEAN SEARCH REPORT
## ON EUROPEAN PATENT APPLICATION NO.

EP 23 20 9147

This annex lists the patent family members relating to the patent documents cited in the above-mentioned European search report.
The members are as contained in the European Patent Office EDP file on
The European Patent Office is in no way liable for these particulars which are merely given for the purpose of information.

19-04-2024

| Patent document cited in search report | | Publication date | Patent family member(s) | | Publication date |
|---|---|---|---|---|---|
| CN 103296652 | B | 02-03-2016 | NONE | | |
| CN 115061020 | A | 16-09-2022 | NONE | | |
| WO 2018227466 | A1 | 20-12-2018 | CN | 110024249 A | 16-07-2019 |
| | | | EP | 3639336 A1 | 22-04-2020 |
| | | | US | 2019296543 A1 | 26-09-2019 |
| | | | WO | 2018227466 A1 | 20-12-2018 |

EPO FORM P0459

For more details about this annex : see Official Journal of the European Patent Office, No. 12/82